# FASCICULE DE BREVET EUROPEEN

(11) **EP 1 051 737 B1**
(45) Date de publication et mention de la délivrance du brevet: **02.04.2003**
(21) Numéro de dépôt: 99901632.2
(22) Date de dépôt: 27.01.1999
(51) Int. Cl.: H01L 21/00

(54) **PROCEDE DE REALISATION D'UNE STRUCTURE SiCOI**
VERFAHREN ZUR HERSTELLUNG EINER SiCOI-STRUKTUR
METHOD OF PRODUCING A SiCOI STRUCTURE

(30) Priorité: 28.01.1998 FR 9800899
(43) Date de publication de la demande: 15.11.2000
(73) Titulaire: COMMISSARIAT A L'ENERGIE ATOMIQUE, 75015 Paris (FR)
(72) Inventeur: DI CIOCCIO, Léa, F-38330 Saint-Ismier (FR)
(74) Mandataire: Weber, Etienne Nicolas
(86) Numéro de dépôt international: FR9900155
(87) Numéro de publication internationale: WO99039371

(56) Documents cités:
- US-A- 5 563 428
- TONG Q -Y ET AL: "A FEASIBILITY STUDY OF SIC ON OXIDE BY WAFER BONDING AND LAYER TRANSFERRING" PROCEEDINGS OF THE INTERNATIONAL SOI CONFERENCE, PALM SPRINGS, OCT. 5 - 7, 1993, no. CONF. 19, 5 octobre 1993 (1993-10-05), page 60/61 XP000470402 INSTITUTE OF ELECTRICAL AND ELECTRONICS ENGINEERS
- DI CIOCCIO L ET AL: "Silicon carbide on insulator formation by the Smart-Cut(R) process" MATERIALS SCIENCE AND ENGINEERING B, vol. 46, no. 1-3, avril 1997 (1997-04), page 349-356 XP004085343

## Description

### Domaine technique

La présente invention concerne un procédé particulier de réalisation d'une structure carbure de sillicium sur isolant, dite structure SiCOI.

L'invention trouve des applications dans les domaines de la micro-électronique et de l'optoélectronique pour la réalisation de substrats tels que des substrats comportant une couche de GaN. Ce matériau est un semi-conducteur à large bande interdite et permet la réalisation de dispositifs électro-optiques, tels que des diodes électroluminescentes ou des lasers, fonctionnant dans le spectre de l'ultraviolet et du bleu.

L'invention trouve également des applications dans la fabrication de microsystèmes aptes à fonctionner dans des environnements hostiles tels que des environnements à haute température ou des atmosphères corrosives. Dans ce cas, le procédé de l'invention permet, par exemple, de fournir de fines membranes de carbure de silicium, aptes à supporter les contraintes de l'environnement hostile.

### Etat de la technique antérieure

Comme indiqué précédemment, le nitrure de gallium (GaN) est un matériau particulièrement intéressant, en raison de sa large bande interdite, pour la fabrication de dispositifs électro-optiques. Or, pour de telles applications, il s'avère qu'il n'est pas possible d'obtenir des blocs monocristallins de GaN de taille suffisante.

Ainsi, actuellement, on réalise des substrats comportant une couche de GaN que l'on a fait croître par hétéroépitaxie sur un support de saphir ou de carbure de silicium (SiC).

L'utilisation du saphir comme support d'épitaxie conduit à des couches de GaN présentant une grande densité de défauts cristallins. L'utilisation du carbure de silicium (SiC) comme support d'épitaxie permet d'obtenir une meilleur qualité cristalline. Il existe en effet un meilleur accord de paramètre de maille entre le GaN et le SiC.

Le coût très important des substrats de SiC monocristallin constitue cependant un handicap pour son utilisation comme support d'épitaxie.

En raison du coût élevé des substrats monocristallins de SiC il est possible d'avoir recours à des substrats plus économiques qui ne comportent qu'une mince couche superficielle de SiC à la surface d'un substrat de base en silicium.

Cependant, le silicium, le carbure de silicium, et le nitrure de gallium formé ultérieurement, présentent des coefficients de dilatation thermiques assez différents. Des contraintes importantes ainsi qu'une grande densité de défauts apparaissent alors lors de la formation du nitrure de gallium sur un tel substrat.

Ce problème peut être au moins en partie résolu en prévoyant une couche d'oxyde entre le silicium et le carbure de silicium. Cette couche permet de réduire les contraintes dues à une dilatation différentielle et obtenir ainsi un substrat dit "compliant".

De façon connue, il est par exemple possible de réaliser des structures de type carbure de silicium sur isolant (SiCOI) en formant par épitaxie une couche de SiC sur un substrat de type silicium sur isolant (SOI).

Cependant, dans ces cas, il reste un mince film de silicium de la couche superficielle de silicium du SOI, entre le SiC et l'oxyde. Or, ce film de silicium fait perdre en partie les propriétés de "compliance" obtenues avec la couche d'oxyde de la structure SOI. De plus, lors de l'épitaxie du SiC, des cavités se forment dans la couche d'oxyde et des défauts apparaissent dans la couche de SiC.

Il est possible également de réaliser une carburation de la couche superficielle de silicium d'un substrat de type silicium sur isolant (SOI), pour la transformer entièrement en SiC et obtenir ainsi une interface SiC/oxyde sans silicium intermédiaire.

Cette solution s'avère cependant difficile à mettre en oeuvre dans la mesure où la couche superficielle de silicium des structures SOI présente généralement une épaisseur de quelques centaines de nanomètres. La carburation du silicium ne permet, en effet, d'obtenir une couche de SiC que sur une épaisseur de l'ordre de la dizaine de nanomètres.

Le document (1) dont la référence est précisée à la fin de la présente description propose un autre procédé pour obtenir un substrat "compliant", comportant une couche de carbure de silicium sur une couche d'oxyde.

Conformément à ce document on forme à la surface d'un substrat de SiC massif, une couche d'oxyde et on implante des ions dans le substrat pour y créer une zone de fragilisation. Cette zone de fragilisation délimite dans le substrat une couche superficielle de SiC en contact avec la couche d'oxyde.

Le substrat de SiC, équipé de la couche d'oxyde, est reporté ensuite sur un substrat cible, en silicium, en mettant en contact la couche d'oxyde avec le substrat cible.

Enfin, un traitement thermique permet de provoquer un clivage du substrat de SiC selon la zone de fragilisation et de libérer la couche superficielle de SiC. Cette couche reste solidaire du substrat cible par l'intermédiaire de la couche isolante.

Le clivage d'un substrat selon une zone de fragilisation, par un traitement thermique, est encore décrit dans le document (2) dont la référence est également précisée à la fin de la présente description.

La structure finalement obtenue présente ainsi, dans l'ordre, un substrat de silicium, une couche d'oxyde puis une couche de carbure de silicium.

Le procédé décrit ci-dessus permet d'obtenir des supports avec une couche de SiC, qui sont moins onéreux que les substrats de SiC monocristallin. Le procédé présente cependant un certain nombre de limitations.

Il apparaît en effet qu'un budget thermique (durée du traitement-température du traitement) relativement important est requis pour le clivage du carbure de silicium. Ce budget thermique est par exemple de 1 heure à 850°C. A titre de comparaison, le clivage du silicium peut être provoqué avec un budget de seulement 30 secondes à 500°C.

Par ailleurs, il s'avère que le carbure de silicium clivé présente une rugosité de surface. La surface de SiC doit ainsi être traitée par polissage avant d'y former d'autres matériaux semi-conducteurs comme le GaN.

Chacun des documents (3) et (4), dont les références sont précisées à la fin de la description, décrit également un procédé de formation d'une structure SiCOI.

### Exposé de l'invention

L'invention a pour but de proposer un procédé de réalisation d'une structure de carbure de silicium sur isolant, ne présentant pas les difficultés ou limitations exposées ci-dessus.

Un but est en particulier de proposer un procédé économique de réalisation d'une structure de carbure de silicium-oxyde-silicium qui ne nécessite pas un budget thermique important lors d'une opération de clivage.

Un but est encore de proposer un tel procédé permettant d'obtenir, dans une telle structure, une couche de SiC avec un excellent état de surface.

Un but est aussi de proposer un procédé de fabrication de supports SiCOI pour une couche de GaN.

Encore un autre but est de permettre l'obtention d'une telle structure (en particulier avec des couches de SiC ou de GaN) de grandes dimensions.

Pour atteindre ces buts l'invention a pour objet un procédé selon la revendication 1.

Selon un mode avantageux, l'apport d'énergie de l'étape d) est choisi parmi un apport d'énergie thermique, d'énergie mécanique, ou d'une combinaison de ces énergies.

Par apport d'énergie thermique, on entend la mise en oeuvre d'un traitement thermique.

Ce traitement thermique peut être mené avec un budget thermique déterminé fonction des différents budgets thermiques utilisés au cours du procédé. En particulier, ce traitement thermique peut tenir compte du ou des échauffements induits par des traitements thermiques de type hors équilibre thermodynamiques tels que ceux pouvant résulter de l'étape d'implantation des ions, et par des traitements thermiques utilisant un chauffage ou un refroidissement du substrat tels que par exemple pour l'implantation, ou un éventuel renforcement de forces de liaisons dans le cas de collage avec un support.

Ce traitement thermique peut tenir compte également de l'utilisation d'autres apports d'énergie tels que l'application de forces mécaniques.

Ainsi à l'étape d), le traitement thermique peut être nul, l'apport d'énergie pouvant n'être alors que sous forme mécanique.

Selon un mode avantageux de l'invention, l'étape e) d'élimination est réalisée selon un mode d'élimination choisi parmi une gravure chimique humide ou sèche, un polissage, une oxydation suivie d'une gravure, ou une combinaison de ces modes.

Selon un aspect particulier de l'invention, entre les étapes a) et b) ou entre les étape b) et c), la couche de matériau semi-conducteur peut être soumise à des traitements, tels qu'en particulier des traitements pour l'élaboration de composants actifs et/ou passifs. Lorsque des composants sont élaborés avant l'étape b), ces traitements sont alors pris en compte pour déterminer les conditions de l'implantation d'ions.

On observe que, dans ce cas, le clivage opéré à l'étape d) du procédé n'a pas lieu dans une couche de carbure de silicium mais dans le silicium du premier substrat. Le clivage peut ainsi être provoqué avec un budget thermique plus faible et laisse par ailleurs intacte la couche de carbure de silicium.

De plus, le procédé de l'invention est adapté à la réalisation de structures avec une couche de SiC de très grande surface.

Lors de l'étape c) du procédé, la couche de matériau semi-conducteur peut être solidarisée du substrat au moyen d'un traitement thermique.

Le même traitement thermique peut être prolongé et mis à profit pour provoquer le clivage de l'étape d) du procédé.

Afin d'obtenir une structure finale avec des propriétés de bonne "compliance", pour laquelle les influences des différences de coefficients de dilatation thermique sont faibles, on peut prévoir une couche d'oxyde entre la couche de matériau semi-conducteur et le substrat de support. Ceci est particulièrement intéressant lorsque la couche de matériau semi-conducteur est du carbure de silicium, et lorsque le substrat est en silicium.

A cet effet, on peut utiliser un substrat de support (cible) présentant une couche superficielle d'isolant et reporter le premier substrat avec la couche de matériau semi-conducteur, sur la couche d'isolant du substrat de support.

On peut aussi, à titre alternatif ou complémentaire, former une couche d'isolant sur la couche de matériau semi-conducteur avant l'étape b) d'implantation d'ions.

La couche d'isolant du substrat de support et/ou la couche d'isolant formée sur la couche de matériau semi-conducteur peuvent être des couches d'oxyde, par exemple.

A la fin du procédé, c'est-à-dire après l'étape e), il est possible d'augmenter l'épaisseur de la couche de matériau semi-conducteur par homoépitaxie.

Dans une mise en oeuvre particulière du procédé, pour la formation de substrats destinés à l'optoélectronique, on peut réaliser une couche superficielle en carbure de silicium sur la structure SiCOI et former sur cette couche, une couche de nitrure de gallium.

La couche de nitrure de gallium peut être formée par hétéroépitaxie.

D'autres caractéristiques et avantages de l'invention ressortiront mieux de la description qui suit, en référence aux figures des dessins annexés. Cette description correspond à un mode de mise en oeuvre particulier de l'invention et est donnée à titre purement illustratif et non limitatif.

### Brève description des figures

- Les figures 1 à 3 sont des coupes schématiques d'un premier substrat lors d'étapes de préparation précédant son report sur un substrat de support, ou substrat cible.
- Les figures 4 et 5 sont des coupes schématiques illustrant l'opération de report du premier substrat sur le substrat de support.
- La figure 6 est une coupe schématique du substrat de support obtenu après clivage du premier substrat.
- La figure 7 est une coupe schématique du substrat de la figure 6 obtenu après un traitement de surface et sur lequel on a rendu plus épaisse une couche superficielle de matériau semi-conducteur.
- La figure 8 est une coupe schématique du substrat de la figure 6 après un traitement de surface et sur lequel on a fait croître une couche de matériau semi-conducteur.

Il convient de noter que, pour des raisons de clarté, les différentes couches de matériau des structures visibles sur les figures sont représentées en échelle libre ; les dimensions de certaines parties étant fortement exagérées.

### Description détaillée d'exemples de modes de mise en oeuvre de l'invention

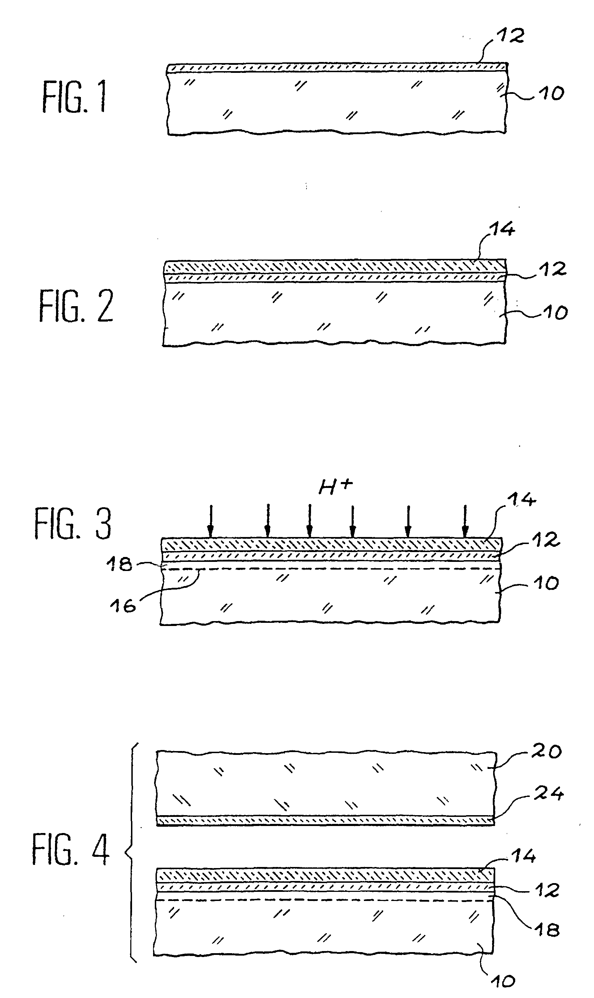

La figure 1 montre un premier substrat 10 en silicium, sur lequel on a formé une couche de carbure de silicium 12.

La couche de carbure de silicium est obtenue, par exemple, par carburation en surface du silicium du substrat 10 par une réaction entre un hydrocarbure et le silicium. Cette réaction a lieu à une température de l'ordre de 1350°C et permet de former une couche de carbure de silicium (SiC) de faible épaisseur. L'épaisseur de la couche de carbure de silicium est de l'ordre de 5 à 10 nm.

On peut observer que le procédé décrit ici peut être mis en oeuvre avec des plaquettes de grand diamètre qui forment le premier substrat.

La figure 2 montre une étape facultative du procédé lors de laquelle on dépose sur la couche de SiC 12, une couche d'oxyde de silicium 14. Cette couche, d'une épaisseur de l'ordre de 500 nm, permet de réduire ultérieurement des effets de dilatations thermiques différentielles entre la couche de carbure de silicium et un substrat de support en silicium, décrit plus loin, sur lequel cette couche est reportée.

L'épaisseur de la couche d'oxyde n'est pas critique et peut être choisie dans une large gamme de valeurs.

La figure 3 montre la formation dans le premier substrat 10 d'une zone de clivage 16. La zone de clivage est formée par implantation d'ions, par exemple d'ions hydrogène. La dose et l'énergie de l'implantation sont choisies en fonction de l'épaisseur des couches de SiC 12 et d'oxyde 14 de façon à former de préférence la zone de clivage sous la couche superficielle 12, dans le substrat 10, le plus près possible de sa surface, c'est-à-dire le plus près possible de l'interface Si/SiC.

Pour une description plus détaillée de la formation d'une zone de clivage, on peut se reporter au document (2) déjà mentionné.

La zone de clivage 16 délimite dans le substrat de silicium 10 une couche superficielle de silicium 18.

Comme le montre la figure 4, le premier substrat 10, équipé de la couche de carbure de silicium 12 et de la couche d'oxyde 14, est approché d'un deuxième substrat de support 20, ce deuxième substrat est en silicium et présente sur l'une de ses faces une couche d'oxyde de silicium 24. Le substrat de support 20 est encore appelé substrat cible.

Les substrats 10 et 20 sont orientés de façon à mettre en regard les couches d'oxyde 14 et 24 qui ont été préalablement nettoyées en vue d'un collage.

Il convient de noter ici que la couche d'oxyde 24 formée à la surface du deuxième substrat 20, de même que la couche d'oxyde 14 du premier substrat 16 sont facultatives.

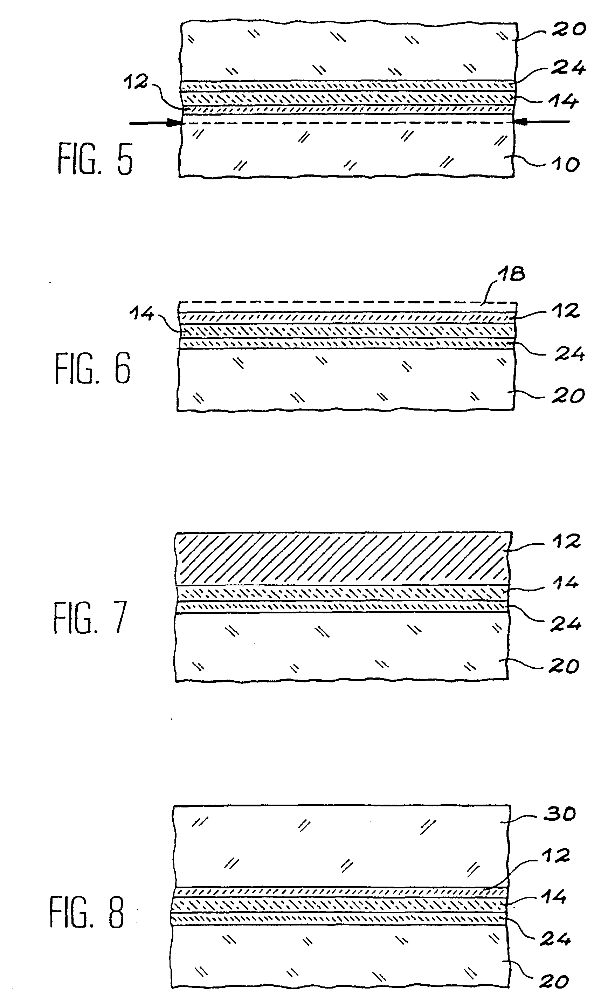

La figure 5 montre le report du premier substrat 10 sur le deuxième substrat 20, en mettant en contact les faces libres de ces substrats, formés respectivement par les couches d'oxyde.

Les couches d'oxyde sont collées l'une à l'autre par adhérence moléculaire. Le collage peut être renforcé par un traitement thermique approprié.

Le traitement thermique est poursuivi, ou un autre traitement thermique est mis en oeuvre, avec un budget thermique suffisant pour provoquer un clivage de la structure de la figure 5 selon la zone de clivage 16. Le clivage est figuré par des flèches.

Après le clivage et après élimination de la partie massive restante du premier substrat, on obtient la structure représentée à la figure 6. L'orientation du deuxième substrat 20 de la figure 6 a été modifiée de 180°, par rapport à la figure 5.

La structure de la figure 6 comporte, dans l'ordre, le substrat de support 20, la couche d'oxyde 24 formée à sa surface, la couche d'oxyde 14 provenant du premier substrat, la couche de carbure de silicium 12 et la fine couche de silicium superficielle 18 provenant également du premier substrat.

La couche superficielle 18 est ensuite retirée de la structure par exemple par une attaque chimique de type humide avec une solution de TMAH.

Pour réaliser des capteurs ou des éléments de micromécanique avec une membrane en carbure de silicium, on peut augmenter l'épaisseur de la couche de carbure de silicium 12 par épitaxie de carbure de silicium sur cette couche.

Cette opération est représentée à la figure 7 sur laquelle l'épaisseur de la couche 12 de SiC est augmentée.

Par épitaxie on peut augmenter l'épaisseur de la couche de carbure de silicium jusqu'à des valeurs de 500 nm à 1 µm par exemple.

Des structures à membrane de SiC suspendue peuvent être obtenues facilement par gravure partielle des couches d'oxyde 24, 14 sous-jacentes.

Dans une autre application du substrat, par exemple dans le domaine de l'optoélectronique, un matériau semi-conducteur peut être formé par hétéroépitaxie sur la couche 12 de SiC après l'élimination de la couche superficielle de silicium.

La figure 8 montre une telle application, dans laquelle une couche de GaN 30 est formée sur la couche de carbure de silicium 12 mise à nu.

La description qui précède ne constitue qu'un exemple particulier de mise en oeuvre de l'invention. Les matériaux choisis et l'épaisseur des couches peuvent varier dans une large gamme en fonction des applications envisagées.

Le procédé de l'invention peut être appliqué à des matériaux autres que le SiC tels que par exemple l'AsGa, le GaN ou du matériau ferroélectrique.

Il permet alors également d'obtenir des couches de matériau de bonne qualité, peu sensibles aux dilatations thermiques et dont l'épaisseur peut être ajustée en fin de procédé, par exemple par épitaxie.

De même, le matériau utilisé pour le substrat de support 20 peut être du saphir.

### DOCUMENTS CITES

***(1)***
   "Smart Cut" Process Offers SiC Structures on Silicon Wafers
   de Brian Dance
   58/Semiconductor International, May 1997
***(2)***
   EP-A-0 533 551
(3)
   TONG Q-Y et al : "A FEASIBILITY STUDY OF SIC ON OXIDE BY WAFER BONDING AND LAYER TRANSFERRING" PROCEEDINGS OF THE INTERNATIONAL SOI CONFERENCE, PALM SPRINGS, OCT.5-7, 1993, n° CONF. 19, 5 OCTOBRE 1993 (1993-10-05), Pages 60/61 XP000470402 INSTITUTE OF ELECTRICAL AND ELECTRONICS ENGINEERS.
(4)
   DI CIOCCIO L ET AL: 'Silicon carbide on insulator formation by the Smart-Cut® process' MATERIALS SCIENCE AND ENGINEERING B, vol. 46, no. 1-3, avril 1997 (1997-04), pages 349-356, XP004085343.

## Revendications

1. Procédé de réalisation d'une structure SiCOI, la structure comprenant un substrat de support (20) et une couche de carbure de silicium (12) sur une face du substrat de support, le procédé comportant les étapes successives suivantes :
a) formation d'une couche de carbure de silicium (12) sur une face d'un premier substrat de silicium (10),
b) implantation d'ions d'espèces gazeuses dans le premier substrat sous ladite face et au voisinage de la couche de carbure de silicium, pour former une zone (16), dite zone de clivage, qui délimite une couche superficielle (18) du premier substrat (10) comprenant la couche de carbure de silicium (12),
c) report du premier substrat (10) ayant la couche de carbure de silicium (12) sur le substrat de support (20), la couche de carbure de silicium (12) étant rendue solidaire du substrat de support (20) à travers d'une couche isolante électrique,
d) apport d'énergie pour provoquer un clivage du premier substrat selon la zone de clivage (16), la couche superficielle (18) du premier substrat restant solidaire de la couche de carbure de silicium (12) et du substrat de support (20) lors de ce clivage,
e) élimination de ladite couche superficielle (18) pour mettre à nu la couche de carbure de silicium (12).

2. Procédé selon la revendication 1, dans lequel, lors de l'étape d) l'apport d'énergie est effectué sous une forme choisie parmi un apport d'énergie thermique, un apport d'énergie mécanique ou un apport d'une combinaison de ces énergies.

3. Procédé selon la revendication 1, dans lequel l'étape e) est mise en oeuvre selon un mode d'élimination choisi parmi une gravure chimique, humide ou sèche, un polissage, une oxydation suivie d'une gravure, ou une combinaison de ces modes.

4. Procédé selon la revendication 1, dans lequel la couche (12) de carbure de silicium est obtenue en faisant réagir le silicium du premier substrat (10) avec un hydrocarbure.

5. Procédé selon la revendication 1, dans lequel on forme une couche d'isolant (14) sur la couche de carbure de silicium (12) avant l'étape b) d'implantation d'ions.

6. Procédé selon la revendication 1, dans lequel on utilise un substrat de support (20) présentant une couche superficielle (24) d'isolant et dans lequel, lors de l'étape c) on reporte le premier substrat (10) avec la couche de carbure de silicium (12), sur la couche d'isolant (24) du substrat de support.

7. Procédé selon la revendications 2 ou 3, dans lequel l'isolant est un oxyde.

8. Procédé selon la revendication 1, dans lequel, après l'étape e), on effectue sur la couche de carbure de silicium (12) une épitaxie du même matériau, afin d'augmenter l'épaisseur de la couche de carbure de silicium (12).

9. Procédé selon la revendication 1, dans lequel, après l'étape e), on forme sur la couche (12) de carbure de silicium une couche (30) de GaN.

10. Procédé selon la revendication 1, dans lequel la couche de carbure de silicium (12) est rendue solidaire du substrat de support (20) par un traitement thermique.

11. Procédé selon la revendication 10, dans lequel ledit traitement thermique pour rendre la couche de carbure de silicium solidaire du substrat de support est prolongé pour provoquer également le clivage de l'étape d).

## Patentansprüche

1. Verfahren zum Anfertigen einer SiCOI-Struktur, wobei die Struktur ein Trägersubstrat (20) und eine Siliciumcarbidschicht (12) auf einer Seite des Trägersubstrats umfasst, und wobei das Verfahren die nachfolgenden sukzessiven Schritte umfasst:
a) Bildung einer Siliciumcarbidschicht (12) auf einer Seite eines ersten Siliciumsubstrats (10),
b) Implantation von Ionen gasförmiger Art in das erste Substrat auf besagter Seite und in die Nachbarschaft der Siliciumcarbidschicht, um einen Bereich (16), genannt Spaltbereich, auszubilden, welcher eine die Siliciumcarbidschicht (12) umfassende Oberflächenschicht (18) des ersten Substrats (10) begrenzt,
c) Übertragung des die Siliciumcarbidschicht (12) aufweisenden ersten Substrats (10) auf das Trägersubstrat (20), wobei die Siliciumcarbidschicht (12) über eine elektrische Isolationsschicht mit dem Trägersubstrat (20) zu einer Einheit gemacht wird,
d) Zufuhr von Energie, um ein Spalten des ersten Substrats gemäß der Spaltzone (16) zu bewirken, wobei bei dieser Spaltung die Oberflächenschicht (18) des ersten Substrats mit der Siliciumcarbidschicht (12) und dem Trägersubstrat (20) eine Einheit bleibt,
e) Beseitigung der Oberflächenschicht (18), um die Siliciumcarbidschicht (12) bloßzulegen.

2. Verfahren nach Anspruch 1, bei dem bei dem Schritt d) die Zufuhr von Energie in einer Form, welche aus einer Zufuhr von thermischer Energie, einer Zufuhr von mechanischer Energie oder einer Zufuhr einer Kombination dieser Energien ausgewählt ist, ausgeführt wird.

3. Verfahren nach Anspruch 1, bei dem der Schritt e) gemäß einem Beseitigungsmodus, welcher aus einem nass- oder trockenchemischen Ätzen, einem Polieren, einer von einem Ätzen gefolgten Oxidation, oder einer Kombination dieser Modi ausgewählt ist, bewerkstelligt wird.

4. Verfahren nach Anspruch 1, bei dem die Siliciumcarbidschicht (12) erhalten wird, indem das Silicium des ersten Substrats (10) mit einem Kohlenwasserstoff zur Reaktion gebracht wird.

5. Verfahren nach Anspruch 1, bei dem vor dem Schritt b), der Implantation von Ionen, eine Isolationsschicht (14) auf der Siliciumcarbidschicht (12) ausgebildet wird.

6. Verfahren nach Anspruch 1, bei dem ein Trägersubstrat (20), welches eine Oberflächenschicht (24) aus einem Isolator aufweist, verwendet wird, und bei dem bei dem Schritt c) das erste Substrat (10) mit der Siliciumcarbidschicht (12) auf die Isolationsschicht (24) des Trägersubstrats übertragen wird.

7. Verfahren nach Anspruch 2 oder 3, bei dem der Isolator ein Oxid ist.

8. Verfahren nach Anspruch 1, bei dem nach dem Schritt e) auf der Siliciumcarbidschicht (12) eine Epitaxie desselben Materials ausgeführt wird, mit dem Ziel, die Dicke der Siliciumcarbidschicht (12) zu vergrößern.

9. Verfahren nach Anspruch 1, bei dem nach dem Schritt e) auf der Siliciumcarbidschicht (12) eine GaN-Schicht (30) ausgebildet wird.

10. Verfahren nach Anspruch 1, bei dem die Siliciumcarbidschicht (12) durch eine thermische Behandlung mit dem Trägersubstrat (20) zu einer Einheit gemacht wird.

11. Verfahren nach Anspruch 10, bei dem die thermische Behandlung, um die Siliciumcarbidschicht mit dem Trägersubstrat zu einer Einheit zu machen, verlängert wird, um gleichzeitig das Spalten des Schritts d) zu bewirken.

## Claims

1. Process for fabricating a SiCOI structure which comprises a carrier substrate (20) and a layer of silicon carbide (12) on one surface of the carrier substrate, the process comprising the following successive steps:
a) forming a layer of silicon carbide (12) on one surface of a first silicon substrate (10),
b) implanting ions of gaseous types in the first substrate, under said surface and in the vicinity of the silicon carbide layer to form a zone (16), called a cleavage zone, which delimits a superficial layer (18) in the first substrate (10), comprising the silicon carbide layer (12),
c) transfer of the first substrate (10) having the layer of silicon carbide (12), onto the carrier substrate (20), the silicon carbide layer (12) being made integral with the carrier substrate (20), through an electrically insulating layer,
d) providing energy to cause cleavage of the first substrate along the cleavage zone (16), the superficial layer (18) of the first substrate remaining integral with the silicon carbide layer (12) and with the carrier substrate (20) during this cleavage,
e) removing said superficial layer (18) to uncover the silicon carbide layer (12).

2. Process according to claim 1, in which, during step d) the supply of energy is made in a form chosen from among a supply of thermal energy, a supply of mechanical energy, or a supply of a combination of these energies.

3. Process according to claim 1, in which step e) is implemented according to a removal mode chosen from among wet or dry chemical etching, polishing, oxidation followed by etching, or a combination of these modes.

4. Process according to claim 1, in which the silicon carbide layer (12) is obtained by causing the silicon of the first substrate (10) to react with a hydrocarbon.

5. Process according to claim 1, in which an insulator layer (14) is formed on the silicon carbide layer (12) before ion implantation step b).

6. Process according to claim 1, in which a carrier substrate (20) is used which has a superficial insulator layer (24) and in which, during step c), the first substrate (10) is transferred with the silicon carbide layer (12) onto the insulator layer (24) of the carrier substrate.

7. Process according to claim 2 or 3, in which the insulator is an oxide.

8. Process according to claim 1, in which, after step e), on the silicon carbide layer (12), epitaxial growth of the same material is made in order to increase the thickness of the silicon carbide layer (12).

9. Process according to claim 1, in which, after step e), on silicon carbide layer (12), a layer (30) of GaN is formed.

10. Process according to claim 1, in which the silicon carbide layer (12) is made integral with the carrier substrate (20) by heat treatment.

11. Process according to claim 10, in which said heat treatment, to render the silicon carbide layer integral with the carrier substrate, is extended to additionally cause the cleavage of step d).
